# EUROPEAN PATENT SPECIFICATION

(11) **EP 4 120 295 B1**
(45) Date of publication and mention of the grant of the patent: **25.12.2024**
(21) Application number: 22182176.2
(22) Date of filing: 30.06.2022
(51) Int. Cl.: H01F 27/08, H01F 37/00, H01F 27/02, H02M 7/00, H01F 27/22

(54) **HEAT DISSIPATION STRUCTURE FOR REACTOR AND INVERTER**
WÄRMEABLEITSTRUKTUR FÜR REAKTOR UND WECHSELRICHTER
STRUCTURE DE DISSIPATION THERMIQUE POUR RÉACTEUR ET ONDULEUR

(30) Priority: 09.07.2021 CN 202121581781 U
(43) Date of publication of application: 18.01.2023
(73) Proprietor: Sungrow Power Supply Co., Ltd., Hefei, Anhui 230088 (CN)
(72) Inventor: ZHOU, Jie, Hefei (CN); YU, Renbin, Hefei (CN)
(74) Representative: Zacco Norway AS

(56) References cited:
- CN-A- 106 971 823
- DE-A1- 102008 029 187
- JP-U- S5 520 277
- US-A1- 2018 098 457

## Description

### FIELD

The present application relates to the field of inverters, in particular to a heat dissipation structure for a reactor and an inverter.

### BACKGROUND

A manufacturing process for a reactor of a string inverter is as follows. A housing with teeth is firstly die-casted, then a reactor body including a magnetic core and a coil is placed into the housing, and potting sealant is filled into the housing to ensure the housing to be leak-tight, so as to achieve high protection effects such as waterproof and dustproof.

The above-described reactor mainly utilizes a cooling method in which the heat radiated by the reactor body is dissipated to the outside by providing a separate cooling fan or using a wind for cooling a power module. The heat dissipation effect of the reactor body is poor due to the reactor body being wrapped by the potting sealant and the housing, and the current carrying density of the coil is relatively low under the same conditions.

In addition, since the reactor body needs to be wrapped by the housing and the potting sealant, the entire reactor has a relatively large size and a relatively heavy weight.

In summary, how to improve the heat dissipation effect of the reactor on the premise that protection requirements are met is an urgent problem to be solved by those skilled in the art.
US 10440864B2 discloses a power conversion device such that heat dissipation can be improved is obtained. The power conversion device includes a power conversion circuit unit that converts direct current into alternating current using a semiconductor switching element, a heatsink on which the power conversion circuit unit is mounted, and which has a first passage through which a cooling medium is caused to pass, and a frame body that houses the power conversion circuit unit, seals the power conversion circuit unit between the frame body and the heatsink, and has a second passage through which a cooling medium is caused to pass, wherein the first passage and second passage are connected at an interface between the heatsink and frame body, thereby configuring a cooling passage.
US 2018/098457 A1 discloses a power converter including a stack of a plurality of semiconductor modules, each of which incorporates semiconductor elements, and a plurality of cooling conduits, though each of which a coolant flows to cool the semiconductor modules, at least one electronic component such as a reactor electrically connected to the semiconductor modules, and a cooling plate for cooling the at least one electronic component. The stack, the at least one electronic component, and the cooling plate are arranged in a stacking direction of the stack. The cooling plate is connected to the cooling conduits and has an intra-plate pathway formed therein thorough which the coolant flows in a direction perpendicular to the stacking direction. The cooling plate has a larger area than each cooling conduit when viewed from the stacking direction.
DE102008029187A1 discloses a housing has a tub-shaped or pot shaped housing part and a cap or plate shaped housing part that are detachably connected by a seal. A pipe i.e. air duct, is attached inside the housing such that an inlet and an outlet are arranged in an opening of surfaces of the housing. Cooling fins are axially or radially arranged at the pipe. The surfaces comprising the outlet and the inlet are arranged adjacent to each other. The cross section of the housing is circular, square, oval or rectangular. CN106971823A discloses a transformer with water and air mixed cooling applicable to high power density. The transformer is characterized in that a transformer body is arranged in a fuel tank, and a finned water cooling plate is embedded in the top of the duct forced air cooling fuel tank; the purpose of heat dissipation of 70% or above of thermal power of the whole transformer is achieved by means of the top water cooling plate in a forced water cooling way, and the risk of leakage occurrence caused by pipeline corrosion is completely avoided; by adopting a blower of a water cooling system to conduct forced air cooling on air ducts, the problem that a sandwich-type fuel tank is high in cost, difficult to manufacture and big in coolant waste is solved; the transformer with water and air mixed cooling has the advantages of being quick in heat dissipation, high in efficiency and convenient to manufacture and maintain. JPS5520277U discloses an internal fan disclosed in a closed cavity that houses a reactor. The fan creates an air flow that transports heat from the reactor to the outer walls of the housing.

### SUMMARY

In view of this, an object of the present application is to provide a heat dissipation structure for a reactor, which can improve the heat dissipation effect of the reactor on the premise that protection requirements are met. Another object of the present application is to provide an inverter including the above-described heat dissipation structure for the reactor.

In order to achieve the above objects, the following technical solutions are provided according to the present application.

A heat dissipation structure for a reactor body according to independent claim 1 includes: a housing, and one or more heat dissipation pipes; the one or more heat dissipation pipes are disposed in a cavity of the housing and is connected to the housing in a leak-tight manner, a closed cavity is formed between the one or more heat dissipation pipes and the housing, and the reactor body is to be disposed in the closed cavity. The heat dissipation structure for the reactor further includes at least one inner fan disposed in the closed cavity.

Optionally, each of pipe openings at both ends of the one or more heat dissipation pipes extends beyond the housing, and the one or more heat dissipation pipes are used for cooling medium to flow through.

Optionally, the heat dissipation structure for the reactor further includes: one or more heat dissipation fins disposed in the closed cavity, which are disposed at at least one of the one or more heat dissipation pipes.

Optionally, at least one of the one or more heat dissipation fins is disposed at only one of the one or more heat dissipation pipes.

Optionally, at least one of the one or more heat dissipation fins is disposed at at least two of the one or more heat dissipation pipes.

Optionally, at least two heat dissipation fins are disposed at the at least one of the one or more heat dissipation pipes, and are sequentially distributed along an axial direction of the at least one heat dissipation pipe or sequentially distributed along a circumferential direction of the at least one heat dissipation pipe.

Optionally, the heat dissipation structure for the reactor further includes an outer fan and an air duct disposed outside the housing, where an air outlet of the outer fan and an inlet of the one or more heat dissipation pipes are communicated through the air duct, or an air inlet of the outer fan and an outlet of the one or more heat dissipation pipes are communicated through the air duct.

Optionally, one end of the air duct is connected to the outer fan in a leak-tight manner, the other end of the air duct is connected to the housing in a leak-tight manner, and the air duct is covered at the periphery of the one or more heat dissipation pipes.

Optionally, a number of the at least one inner fan is two, and two inner fans are disposed at two ends of the housing respectively, one of the two inner fans being disposed on one side of the reactor body and the other inner fan being disposed on the other side of the reactor body.

Optionally, the one or more heat dissipation pipes are distributed in rows, and the heat dissipation pipes in any two rows are sequentially distributed along an airflow direction, where in the heat dissipation pipes in adjacent rows, the heat dissipation pipes in one row and the heat dissipation pipes in the other row are alternatively arranged.

Optionally, the one or more heat dissipation fins are provided in groups, and any two groups of the heat dissipation fins are sequentially distributed in an airflow direction, where in adjacent two groups of the heat dissipation fins, the heat dissipation fins in one group and the heat dissipation fins in the other group are alternatively arranged.

Optionally, the housing is in a shape of a rectangular solid, and an axial direction of the one or more heat dissipation pipes is parallel to a width direction of the housing.

Optionally, the one or more heat dissipation pipes are fixedly connected with the housing.

Optionally, the one or more heat dissipation pipes are welded to the housing or fixed to the housing through a flange.

In the heat dissipation structure for the reactor according to the present application, heat exchange occurs between the air in the closed cavity and the heat dissipation pipes, and the heat in the heat dissipation pipes is dissipated through the housing, thereby realizing the heat dissipation of the reactor body, and the heat in the closed cavity is directly dissipated to the outside through the heat dissipation pipes and the housing, which improves the heat dissipation effect of the reactor in comparison with the conventional technology. In addition, the heat dissipation pipes are connected to the housing in a leak-tight manner, the closed cavity is formed by the heat dissipation pipes and the housing, and the reactor body is disposed in the closed cavity. Thus the protection requirements of the reactor, for example the high protection requirements of being waterproof and dustproof, can be met. Therefore, the above-described heat dissipation structure for the reactor allows to improve the heat dissipation effect of the reactor under the premise that the protection requirements are met.

In addition, the heat dissipation structure for the reactor according to the present application allows to improve the heat dissipation effect of the reactor, the current carrying density of the coil of the reactor body can be increased and the diameter of copper wires can be reduced under the same conditions, thereby reducing the usage of copper and effectively reducing the cost and weight.

In addition, in the heat dissipation structure for the reactor according to the present application, the closed cavity is formed between the heat dissipation pipes and the housing, and potting sealant is not provided. The size, weight, and cost of the entire reactor are reduced in comparison with the conventional technology.

Based on the heat dissipation structure for the reactor provided above, the present application further provides an inverter including a heat dissipation structure for a reactor, and the heat dissipation structure for the reactor is any one of the heat dissipation structures for the reactor described above.

Optionally, the housing is fixed to one side of an inverter main body housing.

### BRIEF DESCRIPTION OF THE DRAWINGS

For more clearly illustrating embodiments of the present application or the technical solutions in the conventional technology, drawings referred to for describing the embodiments or the conventional technology will be briefly described hereinafter. Apparently, the drawings in the following description are only examples of the present application, and for those skilled in the art, other drawings may be obtained based on the drawings provided without any creative efforts.
Figure 1 is a schematic diagram showing the structure of a heat dissipation structure for a reactor according to an embodiment of the present application;
Figure 2 is a front sectional view of the structure shown in Figure 1;
Figure 3 is a top sectional view of the structure shown in Figure 1;
Figure 4 is a side sectional view of the structure shown in Figure 1;
Figure 5 is another schematic diagram showing the structure of a heat dissipation structure for a reactor according to an embodiment that does not form part of the present invention; and
Figure 6 is an installation schematic diagram of a heat dissipation structure for a reactor according to an embodiment of the present application.

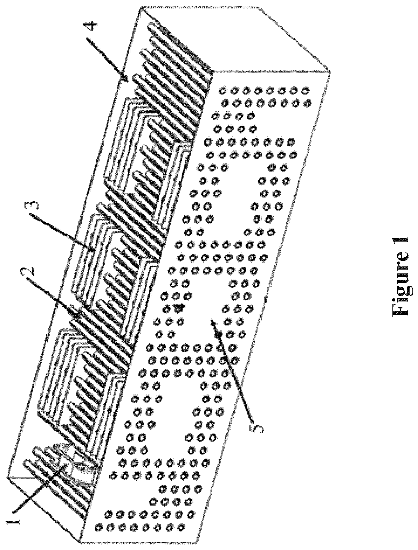

In Figures 1-6, an inner fan 1, a heat dissipation pipe 2, a heat dissipation fin 3, a closed cavity 4, a housing 5, a reactor body 6, a magnetic core 61, a coil 62, an air duct 7, an outer fan 8, an inverter main body housing 9, and potting sealant 10 are illustrated.

### DETAILED DESCRIPTION

The technical solutions according to the embodiments of the present application will be described clearly and completely hereafter in conjunction with the drawings in the embodiments of the present application. It is apparent that the described embodiments are only a part of the embodiments according to the present application, rather than all of the embodiments. Based on the embodiments in the present application, all of other embodiments, made by those skilled in the art without any creative efforts, fall into the scope of protection of the present application that is only defined in and limited by the claims.

As shown in Figures 1-6, the heat dissipation structure for the reactor according to an embodiment of the present application includes: a housing 5, a reactor body 6, and one or more heat dissipation pipes 2. The one or more heat dissipation pipes 2 are disposed in a cavity of the housing 5 and are connected to the housing 5 in a leak-tight manner. A closed cavity 4 is formed between the one or more heat dissipation pipes 2 and the housing 5, and the reactor body 6 is disposed in the closed cavity 4.

It should be noted that the above-described reactor body 6 includes a magnetic core 61 and a coil 62 wound around the magnetic core 61. In Figure 1, the housing 5 is only partially shown, and a top cover of the housing 5 is not shown.

In the heat dissipation structure for the reactor according to above embodiments, heat exchange occurs between the air in the closed cavity and the one or more heat dissipation pipes 2, and the heat in the one or more heat dissipation pipes 2 is dissipated through the housing 5, thereby realizing the heat dissipation of the reactor body 6. The heat in the closed cavity is directly dissipated to the outside through the one or more heat dissipation pipes 2 and the housing 5, which improves the heat dissipation effect of the reactor in comparison with the conventional technology. In addition, the one or more heat dissipation pipes 2 are connected to the housing 5 in a leak-tight manner, a closed cavity is formed by the one or more heat dissipation pipes 2 and the housing 5, and the reactor body 6 is disposed in the closed cavity. Thus the protection requirements of the reactor, for example the high protection requirements of waterproof and dustproof, can be met. Therefore, the above-described heat dissipation structure for the reactor allows to improve the heat dissipation effect of the reactor under the premise that the protection requirements are met.

In addition, the heat dissipation structure for the reactor according to the above embodiments allows to improve the heat dissipation effect of the reactor. The current carrying density of the coil 62 of the reactor body 6 can be increased and the diameter of copper wires can be reduced under the same conditions, thereby reducing the usage of copper and effectively reducing the cost and weight.

In addition, in the heat dissipation structure for the reactor according to the above embodiments, the closed cavity 4 is formed by the one or more heat dissipation pipes 2 and the housing 5, and potting sealant is not provided. The size, weight, and cost of the entire reactor are reduced in comparison with the conventional technology.

In order to further improve the heat dissipation effect, each of pipe openings at both ends of the above-described one or more heat dissipation pipes 2 extends beyond the housing 5, and the heat dissipation pipes 2 are used for cooling medium to flow through.

It can be understood that each of the pipe openings at both ends of the above-described one or more heat dissipation pipes 2 extends beyond the housing 5 to ensure the inflow and outflow of the cooling medium. Specifically, the pipe openings of the heat-dissipating pipes 2 can be aligned with the outer wall of the housing 5, protrude from the outer wall of the housing 5, or be embedded in the outer wall of the housing 5. In the actual application process, selection can be made according to actual needs, which is not limited in the embodiments. The type of the above cooling medium can be selected according to actual needs, which is not limited in the embodiments.

In the heat dissipation structure for the reactor according to the above embodiments, the cooling medium, when flowing through the one or more heat dissipation pipes 2, exchanges heat with the air in the closed cavity 4, that is, the cooling medium, when flowing through the one or more heat dissipation pipes 2, takes away the heat in the closed cavity 4. Therefore, the heat dissipation of the reactor body 6 is realized, and the heat dissipation effect of the reactor is further improved.

In order to ensure that each of the pipe openings at both ends of the one or more heat dissipation pipes 2 extends beyond the housing 5, the housing 5 is provided with through holes into which the one or more heat dissipation pipes 2 are inserted. At the through holes, the outer wall of the heat dissipation pipes 2 and the housing 5 are connected in a leak-tight manner.

The number of the above-described heat dissipation pipes 2 can be selected according to actual needs. In order to improve the heat dissipation effect, the number of the heat dissipation pipe 2 can be at least two. The arrangement of the at least two heat dissipation pipes 2 is selected according to actual needs. For example, the at least two heat dissipation pipes 2 are arranged in rows or columns, which is not limited in the embodiments.

Each of the above-described heat dissipation pipes 2 can be of a straight pipe, a curved pipe or a pipe with other shapes, which can be selected according to actual needs. In order to shorten the cooling path of the cooling medium, the above-described heat dissipation pipes 2 can be of a straight pipe.

In order to improve the heat dissipation effect, the above-described heat dissipation structure for the reactor further includes one or more heat dissipation fins 3 disposed in the closed cavity 4, which are disposed at at least one of the one or more heat dissipation pipes 2.

The shape of the above-described heat dissipation fins 3 can be selected according to actual needs, for example, each of the above-described heat dissipation fins 3 are of a shape of a sheet or a needle, et al..

The arrangement of the heat dissipation fins 3 can be selected according to actual needs. For example, the one or more heat dissipation fins 3 can be disposed at only one heat dissipation pipe 2. Alternatively, the one or more heat dissipation fins 3 are disposed at the at least two heat dissipation pipes 2.

Specifically, at least two heat dissipation fins 3 are disposed at the at least one heat dissipation pipe 2, and are sequentially arranged along an axial direction of the at least one heat dissipation pipe 2. Alternatively, the heat dissipation fins 3 disposed at the at least one heat dissipation pipe 2 can be arranged along a circumferential direction of the at least one heat dissipation pipe 2.

In the actual application process, the above-described heat dissipation fins 3 disposed at the heat dissipation pipes 2 can also be arranged in other ways, which is not limited to the above embodiments.

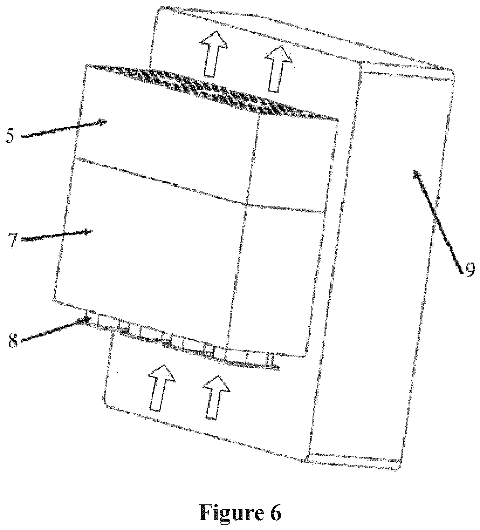

In the actual application process, the cooling medium flowing through the heat dissipation pipes 2 can be water, air or refrigerant, etc., which can be selected according to actual needs. For the convenience of application, the above-described cooling medium can be air. In order to facilitate the cooling medium flowing through the above-described heat dissipation pipes 2, as shown in Figure 6, the above-described heat dissipation structure for the reactor further includes an outer fan 8 and an air duct 7 disposed outside the housing 5, and an air outlet of the outer fan 8 and an inlet of the heat dissipation pipes 2 are communicated through the air duct 7, or an air inlet of the outer fan 8 and an outlet of the heat dissipation pipes 2 are communicated through the air duct 7.

It can be understood that the pipe opening at one end of the above-described heat dissipation pipes 2 is an inlet of the heat dissipation pipes 2, and the pipe opening at the other end of the heat dissipation pipes 2 is an outlet of the heat dissipation pipes 2. The hollow arrows in Figure 6 indicate the airflow direction.

In order to facilitate the arrangement of the air duct 7, one end of the air duct 7 is connected to the outer fan 8 in a leak-tight manner, the other end of the air duct 7 is connected to the housing 5 in a leak-tight manner, and the air duct 7 covers the periphery of the inlets of all of the heat dissipation pipes 2. In this case, the number of the air duct 7 is one.

Specifically, if the air outlet of the outer fan 8 and the inlet of the heat dissipation pipes 2 are communicated through the air duct 7, then one end of the air duct 7 is connected to the air outlet of the outer fan 8 in a leak-tight manner, and the other end of the above-described air duct 7 covers the periphery of the inlets of all of the heat dissipation pipes 2. If the air inlet of the outer fan 8 and the outlet of the heat dissipation pipes 2 are communicated through the air duct 7, one end of the above-described air duct 7 is connected with the air inlet of the outer fan 8 in a leak-tight manner, and the other end of the air duct 7 covers the periphery of the outlet of all of the heat dissipation pipes 2.

In the actual application process, the above-described air duct 7 may also be selected to be other structures, and the number of the above-described air duct 7 may be two or more than two, which is not limited to the above-described embodiments.

In order to further improve the heat dissipation effect, the above-described heat dissipation structure for the reactor further includes at least one inner fan 1 disposed in the closed cavity 4.

In the above-described structure, the airflow is formed in the closed cavity 4, and the heat dissipation effect of the air and the heat dissipation pipes 2 is enhanced by providing the inner fan 1. Moreover, the turbulence to the airflow is realized, and the heat dissipation effect is also improved under the effects of the heat dissipation pipes 2.

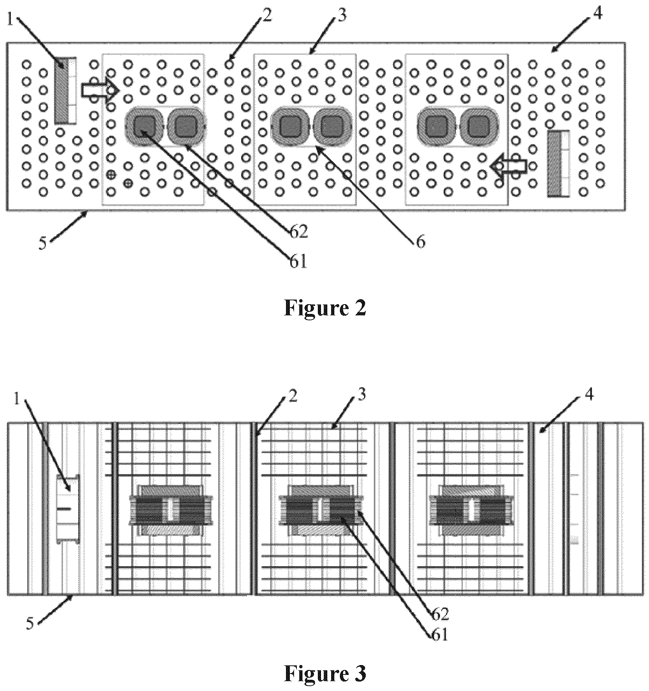

The number of the inner fan 1 can be selected according to actual needs, which is not limited in this embodiment. In order to facilitate the airflow flowing in the closed cavity 4, the number of the above-described inner fan 1 can be two and two inner fans 1 are disposed at two ends of the housing 5 respectively. One inner fan 1 of the two inner fans 1 is disposed on one side of the reactor body 6, and the other inner fan 1 is disposed on the other side of reactor body 6, as shown in Figure 2. It can be understood that the above-described inner fan 1 is in the circulating airflow. The hollow arrows in Figure 2 indicate the airflow direction.

In the actual application process, the number of the above-described inner fan 1 can also be three or more than three, which is not limited to the above-described embodiments.

In the above-described structure, if the heat dissipation fins 3 are provided in the closed cavity 4, a gap, used for the airflow in the closed cavity 4 to pass through, can be provided between two adjacent heat dissipation fins 3.

In order to improve the turbulence effect of the heat dissipation pipes 2, the above-described heat dissipation pipes 2 can be arranged in a row, and the heat dissipation pipes 2 in any two rows are sequentially arranged along an airflow direction, and in the heat dissipation pipes 2 in adjacent rows, the heat dissipation pipes 2 in one row and the heat dissipation pipes 2 in the other row are alternatively arranged. It can be understood that the airflow direction is the flow direction of the airflow generated by the inner fan 1 in the closed cavity. The above-described the heat dissipation pipes 2 in one row and the heat dissipation pipes 2 in the other row that are alternatively arranged can be understood as that the projections of the heat dissipation pipes 2 in one row and the heat dissipation pipes 2 in the other row along the airflow direction do not overlap or only partially overlap.

Specifically, as shown in Figure 2, each row of heat dissipation pipes 2 includes at least two heat dissipation pipes 2, which are sequentially distributed in the height direction of the housing 5. The adjacent two rows of heat dissipation pipes 2 are sequentially distributed along the length direction of the housing 5. In two adjacent rows of heat dissipation pipes 2, the heat dissipation pipes 2 in one row and the heat dissipation pipes 2 in the other row are alternatively arranged, that is, the projections of the heat dissipation pipes 2 in one row and the heat dissipation pipes 2 in the other row along the length direction of the housing 5 do not overlap or only partially overlap.

In each row of the heat dissipation pipes 2, any two heat dissipation pipes 2 can be sequentially arranged in a direction perpendicular to the airflow direction or in other directions, as long as it is ensured that the airflow can pass between the two adjacent heat dissipation pipes 2.

In order to improve the turbulence effect of the heat dissipation fins 3, the heat dissipation fins 3 can be provided in groups, and any two groups of heat dissipation fins 3 are sequentially distributed in the airflow direction. In the adjacent two groups of heat dissipation fins 3, the heat dissipation fins 3 in a group and in the other group are alternatively arranged. It can be understand that the heat dissipation fins 3 in a group and in the other group have non-overlapped or partially-overlapped projections in the airflow direction. It can be understood that the projections of the heat dissipation fins 3 in one group and the heat dissipation fins 3 in the other group along the airflow direction do not overlap or only partially overlap. The airflow direction is the flow direction of the airflow generated by the inner fan 1 in the closed cavity.

In each group of the heat dissipation fins 3, any two heat dissipation fins 3 may be sequentially arranged in a direction perpendicular to the airflow direction, or may be sequentially arranged in other directions, as long as it is ensured that the airflow can pass between the two adjacent heat dissipation fins 3.

In the actual application process, in order to improve the heat dissipation effect to a largest extent, the above-described heat dissipation structure for the reactor includes an inner fan 1, an outer fan 8 and an air duct 7. The inner fan 1 quickly transfer the heat emitted by the reactor body 6 to the air through turbulence. Then the heat in the air is transferred to the heat dissipation pipes 2 through convection heat exchange, and the outer fan 8 blows the cold air into the heat dissipation pipes 2 and takes away the heat on the heat dissipation pipes 2 and dissipates the heat to the outside, so as to realize the heat dissipation of the reactor body 6.

In the actual application process, the number of the reactor body 6 in the above-described closed cavity 4 may be one, two or more than two, which may be selected according to actual needs. In order to facilitate the arrangement of the reactor body 6 and improve the heat dissipation effect, the above-described heat dissipation pipes 2 are disposed at the periphery of the reactor body 6.

In the above-described heat dissipation structure for the reactor, the shape of the housing 5 can be selected according to actual needs. In order to facilitate the installation of the heat dissipation pipes 2, the above-described housing 5 can be in a shape of a rectangular solid. In order to improve the heat dissipation effect, the axial direction of the heat dissipation pipes 2 can be parallel to the width direction of the housing 5, so that the cooling path of the cooling medium can be shortened as much as possible, thereby improving the heat dissipation effect. Certainly, the axial direction of the heat dissipation pipes 2 can also be parallel to the longitudinal direction or the height direction of the housing 5, which is not limited to the above-described embodiments.

In the actual application process, the above-described housing 5 may also be cylindrical or other shapes, which are not limited in this embodiment.

In the above-described heat dissipation structure for the reactor, the type of the housing 5 can be selected according to actual needs. For example, the above-described housing 5 may be a die-cast housing, which is not limited in this embodiment.

In the above-described heat dissipation structure for the reactor, the heat dissipation pipes 2 are fixedly connected with the housing 5. Specifically, the heat dissipation pipes 2 can be welded to the housing 5, the heat dissipation pipes 2 are fixed to the housing 5 through a flange, or the heat dissipation pipes 2 are bonded to the housing 5. In order to facilitate disassembly and maintenance, the above-described heat dissipation pipes 2 can be detachably and fixedly connected to the housing 5, for example, the heat dissipation pipes 2 are fixed to the housing 5 through a flange. Certainly, the above-described heat dissipation pipes 2 can also be fixedly connected to the housing 5 by other means, which is not limited in this embodiment.

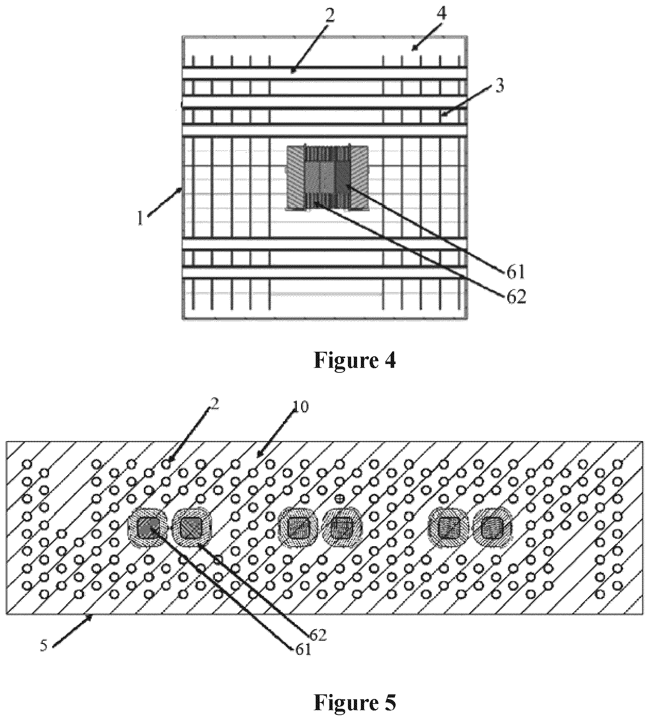

In an embodiment not forming part of the present invention, the housing 5 may be provided with potting sealant 10, as shown in Figure 5. In the inventive examples, the housing 5 is not provided with the potting sealant 10, as shown in Figures 1-4.

In order to improve the heat dissipation effect, the above-described housing 5 can be provided with the potting sealant 10, so that the heat dissipation pipes 2 pass through the potting sealant 10, which reduces the thermal resistance from the heat in the closed cavity 4 to the heat dissipation pipes 2, thereby improving the heat radiation effect. It can be understood that, if the housing 5 is provided with the potting sealant 10, the above-described heat dissipation structure for the reactor does not include the inner fan 1. In this case, the volume is larger, the weight is larger, and the cost is higher in comparison with not disposing the potting sealant 10.

Based on the heat dissipation structure for the reactor according to above-described embodiments, an inverter is further provided according to the embodiment. The inverter includes a heat dissipation structure for a reactor, and the heat dissipation structure for the reactor is the heat dissipation structure for the reactor described in the above embodiments.

Since the heat dissipation structure for the reactor according to above embodiments has the above technical effects, and the above-described inverter includes the above-described heat dissipation structure for the reactor, the above-described inverter also has corresponding technical effects, which will not be repeated herein.

The above-described inverter includes an inverter main body and a heat dissipation structure for a reactor, where the inverter main body has an inverter main body housing 9. In order to facilitate installation, the above-described housing 5 can be fixed to one side of the inverter main body housing 9.

Specifically, the above-described housing 5 is fixed to one side of the inverter main body housing 9 by bolts. If the above-described heat dissipation structure for the reactor includes an air duct 7 and an outer fan 8, the air duct 7 and the outer fan 8 can be fixed to the inverter main body housing 9. Further, the housing 5, the air duct 7 and the outer fan 8 are fixed to the same side of the inverter main body housing 9.

In the above-described inverter, the above-described housing 5 may also be fixed to the inverter main body housing 9 by other means, which are selected according to actual needs and are not limited in this embodiment.

In the practical application process, the above-described heat dissipation structure for the reactor can also be applied to other electronic equipment including a reactor, which is not limited to the above-described inverter.

## Claims

1. A heat dissipation structure configured for a reactor body (6), comprising:
a housing (5) and
one or more heat dissipation pipes (2);
wherein
the one or more heat dissipation pipes (2) are disposed in a cavity of the housing (5) and are connected to the housing (5) in a leak-tight manner, a closed cavity (4) is formed by the one or more heat dissipation pipes (2) and the housing (5), and the reactor body (6) is disposable in the closed cavity (4);
**characterized in that** at least one inner fan (1) is disposed in the closed cavity (4).

2. The heat dissipation structure according to claim 1, wherein each of pipe openings at both ends of the one or more heat dissipation pipes (2) extends beyond the housing (5), and the one or more heat dissipation pipes (2) are used for cooling medium to flow through.

3. The heat dissipation structure according to claim 1, further comprising:
one or more heat dissipation fins (3) disposed in the closed cavity (4), which are disposed at at least one of the one or more heat dissipation pipes (2).

4. The heat dissipation structure according to claim 3, wherein the at least one of the one or more heat dissipation fins (3) is disposed at only one of the one or more heat dissipation pipes (2).

5. The heat dissipation structure according to claim 3, wherein the at least one of the one or more heat dissipation fins (3) is disposed at at least two of the one or more heat dissipation pipes (2).

6. The heat dissipation structure according to claim 3, wherein at least two heat dissipation fins (3) are disposed at the at least one of the one or more heat dissipation pipes (2), and are sequentially arranged along an axial direction of the at least one heat dissipation pipe (2) or sequentially arranged along a circumferential direction of the at least one heat dissipation pipe (2).

7. The heat dissipation structure according to claim 1, further comprising:
an outer fan (8) and an air duct (7) disposed outside the housing (5), wherein an air outlet of the outer fan (8) and an inlet of the one or more heat dissipation pipes (2) are communicated through the air duct (7), or an air inlet of the outer fan (8) and an outlet of the one or more heat dissipation pipes (2) are communicated through the air duct (7).

8. The heat dissipation structure according to claim 7, wherein one end of the air duct (7) is connected to the outer fan (8) in a leak-tight manner, the other end of the air duct (7) is connected to the housing (5) in a leak-tight manner, and the air duct (7) covers the periphery of the one or more heat dissipation pipes (2).

9. The heat dissipation structure according to claim 1, wherein a number of the at least one inner fan (1) is two, and two inner fans (1) are disposed at two ends of the housing (5) respectively, one of the two inner fans (1) is disposed on one side of the reactor body (6) and the other inner fan (1) is disposed on the other side of the reactor body (6), wherein the one or more heat dissipation pipes (2) are arranged in rows, and the heat dissipation pipes (2) in any two rows are sequentially arranged along an airflow direction, wherein in the heat dissipation pipes (2) in adjacent rows, the heat dissipation pipes (2) in one row and the heat dissipation pipes (2) in the other row are alternatively arranged, wherein the one or more heat dissipation fins (3) are provided in groups, and any two groups of the heat dissipation fins (3) are sequentially arranged in an airflow direction, wherein in adjacent two groups of the heat dissipation fins (3), the heat dissipation fins (3) in one group and the heat dissipation fins (3) in the other group are alternatively arranged.

10. The heat dissipation structure according to claim 1, wherein the housing (5) is in a shape of a rectangular solid, and an axial direction of the one or more heat dissipation pipes (2) is parallel to a width direction of the housing (5).

11. The heat dissipation structure according to claim 1, wherein the one or more heat dissipation pipes (2) are fixedly connected with the housing (5).

12. The heat dissipation structure according to claim 11, wherein the one or more heat dissipation pipes (2) are welded to the housing (5) or fixed to the housing (5) through a flange.

13. An inverter comprising the heat dissipation structure according to any one of claims 1 to 12, wherein the housing (5) is fixed to one side of an inverter main body housing (9).

## Patentansprüche

1. Wärmeableitstruktur, die für einen Reaktorkörper (6) konfiguriert ist, umfassend:
ein Gehäuse (5) und
ein oder mehrere Wärmeableitrohre (2);
wobei das eine oder die mehreren Wärmeableitrohre (2) in einem Hohlraum des Gehäuses (5) angeordnet sind und mit dem Gehäuse (5) auf eine leckdichte Weise verbunden sind, ein geschlossener Hohlraum (4) durch das eine oder die mehreren Wärmeableitrohre (2) und das Gehäuse (5) gebildet ist und der Reaktorkörper (6) in dem geschlossenen Hohlraum (4) anordenbar ist;
**dadurch gekennzeichnet, dass** mindestens ein Innenlüfter (1) in dem geschlossenen Hohlraum (4) angeordnet ist.

2. Wärmeableitstruktur nach Anspruch 1, wobei sich jede der Rohröffnungen an beiden Enden des einen oder der mehreren Wärmeableitrohre (2) über das Gehäuse (5) hinaus erstreckt und das eine oder die mehreren Wärmeableitrohre (2) verwendet werden, damit Kühlmedium hindurchfließt.

3. Wärmeableitstruktur nach Anspruch 1, ferner umfassend:
eine oder mehrere Wärmeableitlamellen (3), die in dem geschlossenen Hohlraum (4) angeordnet sind und die an mindestens einem des einen oder der mehreren Wärmeableitrohre (2) angeordnet sind.

4. Wärmeableitstruktur nach Anspruch 3, wobei die mindestens eine der einen oder der mehreren Wärmeableitlamellen (3) an nur einem des einen oder der mehreren Wärmeableitrohre (2) angeordnet ist.

5. Wärmeableitstruktur nach Anspruch 3, wobei die mindestens eine der einen oder der mehreren Wärmeableitlamellen (3) an mindestens zwei des einen oder der mehreren Wärmeableitrohre (2) angeordnet ist.

6. Wärmeableitstruktur nach Anspruch 3, wobei mindestens zwei Wärmeableitlamellen (3) an dem mindestens einen des einen oder der mehreren Wärmeableitrohre (2) angeordnet sind und hintereinander entlang einer axialen Richtung des mindestens einen Wärmableitrohres (2) gestaltet sind oder hintereinander entlang einer Umfangsrichtung des mindestens einen Wärmableitrohres (2) gestaltet sind.

7. Wärmeableitstruktur nach Anspruch 1, ferner umfassend:
einen Außenlüfter (8) und einen Luftkanal (7), der außerhalb des Gehäuses (5) angeordnet ist, wobei ein Luftauslass des Außenlüfters (8) und ein Einlass des einen oder der mehreren Wärmeableitrohre (2) durch den Luftkanal (7) kommuniziert werden oder ein Lufteinlass des Außenlüfters (8) und ein Auslass des einen oder der mehreren Wärmeableitrohre (2) durch den Luftkanal (7) kommuniziert werden.

8. Wärmeableitstruktur nach Anspruch 7, wobei ein Ende des Luftkanals (7) mit dem Außenlüfter (8) auf eine leckdichte Weise verbunden ist, das andere Ende des Luftkanals (7) mit dem Gehäuse (5) auf eine leckdichte Weise verbunden ist und der Luftkanal (7) die Peripherie des einen oder der mehreren Wärmeableitrohre (2) abdeckt.

9. Wärmeableitstruktur nach Anspruch 1, wobei eine Anzahl des mindestens einen Innenlüfters (1) zwei beträgt und zwei Innenlüfter (1) jeweils an zwei Enden des Gehäuses (5) angeordnet sind, einer der zwei Innenlüfter (1) an einer Seite des Reaktorkörpers (6) angeordnet ist und der andere Innenlüfter
(1) an der anderen Seite des Reaktorkörpers (6) angeordnet ist, wobei das eine oder die mehreren Wärmeableitrohre (2) in Reihen gestaltet sind und die Wärmeableitrohre (2) in beliebigen zwei Reihen hintereinander entlang einer Luftstromrichtung gestaltet sind, wobei in den Wärmeableitrohren (2) in benachbarten Reihen die Wärmeableitrohre (2) in einer Reihe und die Wärmeableitrohre
(2) in der anderen Reihe abwechselnd gestaltet sind, wobei die eine oder die mehreren Wärmeableitlamellen (3) in Gruppen bereitgestellt sind und beliebige zwei Gruppen der Wärmeableitlamellen (3) hintereinander in einer Luftstromrichtung gestaltet sind, wobei in zwei benachbarten Gruppen der Wärmeableitlamellen (3) die Wärmeableitlamellen (3) in einer Gruppe und die Wärmeableitlamellen (3) in der anderen Gruppe abwechselnd gestaltet sind.

10. Wärmeableitstruktur nach Anspruch 1, wobei das Gehäuse (5) eine Form eines Quaders aufweist und eine axiale Richtung des einen oder der mehreren Wärmeableitrohre (2) parallel zu einer Breitenrichtung des Gehäuses (5) verläuft.

11. Wärmeableitstruktur nach Anspruch 1, wobei das eine oder die mehreren Wärmeableitrohre (2) fest mit dem Gehäuse (5) verbunden sind.

12. Wärmeableitstruktur nach Anspruch 11, wobei das eine oder die mehreren Wärmeableitrohre (2) mit dem Gehäuse (5) verschweißt oder an dem Gehäuse (5) durch einen Flansch befestigt sind.

13. Wechselrichter, umfassend die Wärmeableitstruktur nach einem der Ansprüche 1 bis 12, wobei das Gehäuse (5) an einer Seite eines Wechselrichterhauptkörpergehäuses (9) befestigt ist.

## Revendications

1. Structure de dissipation thermique configurée pour un corps de réacteur (6), comprenant :
un boîtier (5) et
un ou plusieurs tuyaux de dissipation thermique (2) ;
dans laquelle
l'un ou plusieurs tuyaux de dissipation thermique (2) sont disposés dans une cavité du boîtier (5) et sont reliés au boîtier (5) de manière étanche, une cavité fermée (4) est formée par l'un ou plusieurs tuyaux de dissipation thermique (2) et le boîtier (5), et le corps de réacteur (6) peut être disposé dans la cavité fermée(4) ;
**caractérisée en ce qu'**au moins une soufflante intérieure (1) est disposée dans la cavité fermée (4).

2. Structure de dissipation thermique selon la revendication 1, dans laquelle chacune des ouvertures de tuyau au niveau des deux extrémités de l'un ou plusieurs tuyaux de dissipation thermique (2) s'étend au-delà du boîtier (5), et l'un ou plusieurs tuyaux de dissipation thermique (2) sont utilisés pour permettre au fluide de refroidissement de circuler à travers ceux-ci.

3. Structure de dissipation thermique selon la revendication 1, comprenant en outre :
une ou plusieurs ailettes de dissipation thermique (3) disposées dans la cavité fermée(4), qui sont disposées au niveau d'au moins un parmi l'un ou plusieurs tuyaux de dissipation thermique (2).

4. Structure de dissipation thermique selon la revendication 3, dans laquelle au moins une parmi l'une ou plusieurs ailettes de dissipation thermique (3) est disposée au niveau d'un seul parmi l'un ou plusieurs tuyaux de dissipation thermique (2).

5. Structure de dissipation thermique selon la revendication 3, dans laquelle au moins une parmi l'une ou plusieurs ailettes de dissipation thermique (3) est disposée au niveau d'au moins deux parmi l'un ou plusieurs tuyaux de dissipation thermique (2) .

6. Structure de dissipation thermique selon la revendication 3, dans laquelle au moins deux ailettes de dissipation thermique (3) sont disposées au niveau d'au moins un parmi l'un ou plusieurs tuyaux de dissipation thermique (2), et sont séquentiellement agencées le long d'une direction axiale de l'au moins un tuyau de dissipation thermique (2) ou séquentiellement agencées le long d'une direction circonférentielle de l'au moins un tuyau de dissipation thermique (2).

7. Structure de dissipation thermique selon la revendication 1, comprenant en outre :
une soufflante extérieure (8) et un conduit d'air (7) disposés à l'extérieur du boîtier (5), dans laquelle une sortie d'air de la soufflante extérieure (8) et une entrée de l'un ou plusieurs tuyaux de dissipation thermique (2) sont en communication à travers le conduit d'air (7), ou une entrée d'air de la soufflante extérieure (8) et une sortie de l'un ou plusieurs tuyaux de dissipation thermique (2) sont en communication à travers le conduit d'air (7).

8. Structure de dissipation thermique selon la revendication 7, dans laquelle une extrémité du conduit d'air (7) est reliée à la soufflante extérieure (8) de manière étanche, l'autre extrémité du conduit d'air (7) est reliée au boîtier (5) de manière étanche, et le conduit d'air (7) recouvre la périphérie de l'un ou plusieurs tuyaux de dissipation thermique (2).

9. Structure de dissipation thermique selon la revendication 1, dans laquelle un certain nombre parmi l'au moins une soufflante intérieure (1) est égale à deux, et deux soufflantes intérieures (1) sont disposées au niveau de deux extrémités du boîtier (5) respectivement, une parmi les deux soufflantes intérieures (1) est disposée sur un côté du corps de réacteur (6) et l'autre soufflante intérieure (1) est disposée sur l'autre côté du corps de réacteur (6), dans laquelle l'un ou plusieurs tuyaux de dissipation thermique (2) sont agencés en rangées, et les tuyaux de dissipation thermique (2) dans deux rangées quelconques sont agencés séquentiellement le long d'une direction de flux d'air, dans laquelle dans les tuyaux de dissipation thermique (2) dans des rangées adjacentes, les tuyaux de dissipation thermique (2) dans une rangée et les tuyaux de dissipation thermique (2) dans l'autre rangée sont alternativement agencés, dans laquelle l'une ou plusieurs ailettes de dissipation thermique (3) sont disposées en groupes, et deux groupes quelconques d'ailettes de dissipation thermique (3) sont séquentiellement agencés dans une direction de flux d'air, dans laquelle dans deux groupes adjacents des ailettes de dissipation thermique (3), les ailettes de dissipation thermique (3) dans un groupe et les ailettes de dissipation thermique (3) dans l'autre groupe sont alternativement agencées.

10. Structure de dissipation thermique selon la revendication 1, dans laquelle le boîtier (5) a une forme rectangulaire solide, et une direction axiale de l'un ou plusieurs tuyaux de dissipation thermique (2) est parallèle à une direction de largeur du boîtier (5).

11. Structure de dissipation thermique selon la revendication 1, dans laquelle l'un ou plusieurs tuyaux de dissipation thermique (2) sont reliés de manière fixe au boîtier (5).

12. Structure de dissipation thermique selon la revendication 11, dans laquelle l'un ou plusieurs tuyaux de dissipation thermique (2) sont soudés au boîtier (5) ou fixés au boîtier (5) par l'intermédiaire d'une bride.

13. Onduleur comprenant la structure de dissipation thermique selon l'une quelconque des revendications 1 à 12, dans lequel le boîtier (5) est fixé sur un côté d'un boîtier de corps principal d'onduleur (9).
